(19) Europäisches Patentamt
European Patent Office
Office européen des brevets

(11) **EP 0 500 373 B1**

## (12) EUROPEAN PATENT SPECIFICATION

(45) Date of publication and mention
of the grant of the patent:
**29.04.1998  Bulletin 1998/18**

(51) Int Cl.⁶: **H03J 7/00**

(21) Application number: **92301409.6**

(22) Date of filing: **20.02.1992**

(54) **Time division duplex transmitter-receiver**

Zeitduplex-Sender-Empfänger

Emetteur-récepteur pour système duplex temporel

(84) Designated Contracting States:
**DE FR GB**

(30) Priority: **22.02.1991  JP 50477/91**
**22.02.1991  JP 50478/91**

(43) Date of publication of application:
**26.08.1992  Bulletin 1992/35**

(73) Proprietor: **SONY CORPORATION**
**Tokyo 141 (JP)**

(72) Inventor: **Fukuda, Kunio,**
**c/o Patents Div. Sony Corp.**
**Tokyo 141 (JP)**

(74) Representative: **Turner, James Arthur et al**
**D. Young & Co.,**
**21 New Fetter Lane**
**London EC4A 1DA (GB)**

(56) References cited:
**EP-A- 0 253 680**          **DE-A- 3 626 792**
**GB-A- 2 199 708**          **GB-A- 2 222 040**

## Description

This invention relates to a time division duplex transmitter-receiver.

In a digital cordless telephone system such as a telepoint system, it is known to use a time division duplex (TDD) or time division multiple access/time division duplex (TDMA/TDD) method to allow bidirectional transfer of signals by using one frequency for both transmission and reception.

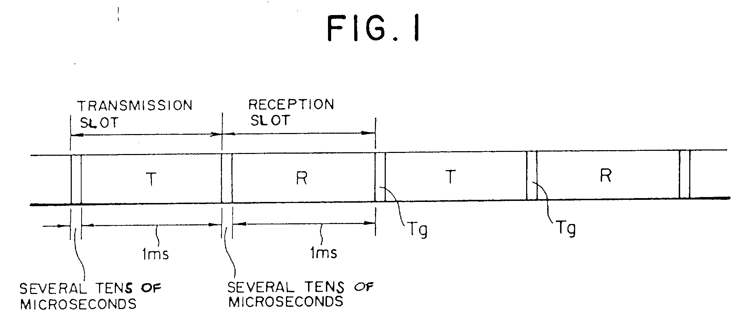

According to the TDD method, as shown in Figure 1 for example, a single channel (frequency) is divided into transmission slots T and reception slots R with respect to time, and such slots T and R are alternately repeated with a guard time Tg therebetween. In an exemplary case, each of the transmission slots T and the reception slots R is 1 millisecond long, and the guard time Tg is several tens of microseconds long. In operation, the cordless telephone set (slave set) transmits a signal to a base station (master set) during the transmission slots T and receives a signal from the base station during the reception slots R.

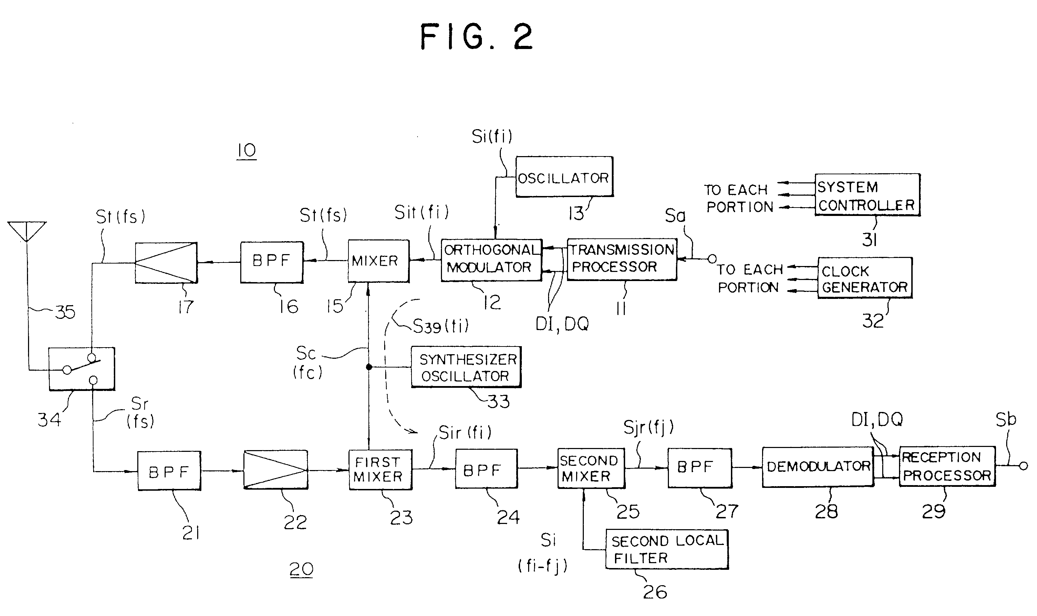

An example of previously proposed transmitting and receiving circuits of a cordless telephone set for use in a TDD system which performs such transmission and reception is shown in Figure 2.

In Figure 2, there are included a transmitting circuit 10, a receiving circuit 20, a system controller 31, and a clock generator 32. The system controller 31 serves to control the entire operation of the cordless telephone and comprises a microcomputer. The clock generator 32 generates various timing clock signals and control signals. The signals obtained from the system controller 31 and the clock generator 32 are supplied to relevant circuits (not shown) respectively.

In the transmitting circuit 10, a sound signal Sa is supplied to a transmission processor 11 which sequentially executes analogue-to-digital (A-D) conversion, time base compression, addition of control data from the system controller 31, and division of the resulting data into two channels (the I and Q channels), so that digital data (DI and DQ) of the I and Q channels are output during every transmission slot T. Such data DI and DQ are supplied as modulating signals to an orthogonal modulator 12. Furthermore a carrier signal (oscillation signal) Si having a frequency fi of 80 mHz for example is output from an oscillator 13 during every transmission slot T and is also supplied to the modulator 12.

Thus, the orthogonal modulator 12 produces, during each transmission slot T, an intermediate frequency signal Sit (of intermediate frequency fi) modulated by the data DI and DQ.

The intermediate frequency signal Sit is supplied to a mixer 15, and a local oscillation signal Sc of a frequency fc is generated from a synthesizer oscillator 33 provided for selection of a transmission-reception channel. The signal Sc is also supplied to the mixer 15, in which the signal Sit is frequency-converted into a transmission signal St of a frequency fs. In such frequency conversion, the following is executed:

$$fs = fi + fc$$

where fc = 2.6 GHz

The frequency fc or channel is set by controlling the synthesizer oscillator 33 by means of the system controller 31.

The transmission signal St is supplied to an antenna 35 via a signal path comprising a band pass filter 16, a power amplifier 17 and a high-frequency switch 34, whereby the signal St is transmitted to the base station or master set.

The switch 34 is changed to a respective position for transmission slots T and reception slots R in response to a control signal obtained from the clock generator 32, so that the antenna 35 is selectively used for both the transmitting circuit 10 and the receiving circuit 20.

Meanwhile in the receiving circuit 20, the signal Sr (of frequency fs) transmitted from the base station or master set during the reception slot R is received at the antenna 35. The signal Sr thus received is supplied to a first mixer 23 via a signal path comprising the switch 34, a band-pass filter 21 and a high-frequency amplifier 22. A local oscillation signal Sc output from an oscillator 33 is also supplied to the first mixer 23, so that the signal Sr is converted into a first intermediate frequency signal Sir. In this case, the intermediate frequency of the signal Sir is equal to the frequency fi of the signal Sit.

The signal Sir thus produced is supplied via a band pass filter 24 to a second mixer 25, and simultaneously a second local oscillation signal Sj from a second local oscillator 26 is also supplied to the mixer 25, whereby the signal Sir is converted into a second intermediate frequency signal Sjr (intermediate frequency fj = 450 kHz), which is then supplied via a band pass filter 27 to a demodulator 28 so as to be demodulated every reception slot R to become digital data DI and DQ. Thereafter the digital data DI and DQ are supplied to a reception processor 29 where a predetermined process for TDD reception is executed to regain the original sound signal Sb. Control data are also output from the processor 29 and are supplied to the system controller 31.

In a TDD cordless telephone using a submicrowave band as mentioned above, there exists a problem with regard to frequency stability. For example, the requisite frequency stability in transmission and reception is 1 part per million (ppm) or so under the conditions including a line frequency fs of 2 GHz, a $\pi/4$-shift quadrature phase shift keying (QPSK) modulation system, a modulation speed of 80 kbps, delay detection for modulation, and a permissible carrier to noise ratio (C/N) deterioration of 3dB.

However, it is difficult in practice to realize a quartz oscillator where the frequency stability is less than 1 ppm, and a considerable increase will be unavoidable in the production cost even if such oscillator can be realized.

Therefore an AFC function is a required in a cordless telephone set, which satisfies the above-described requirements in the submicrowave band.

However, in a TDD system where both the transmission signal St and the reception signal Sr have a burst waveform as shown in Figure 1, it is impossible to form an effective AFC circuit.

Examples of prior systems are described in United Kingdom Patent Publication No. 2199708, European Patent Publication No. 0253680, German Patent No. 3626792 and United Kingdom Patent Publication No. 2222040.

UK Patent Publication No. 2199708 discloses a system for digital AFC in a FM receiver. The system compares the received frequency against a reference frequency and outputs digital signals indicative of the difference therebetween. The difference signal is periodically used to control the received frequency.

European Patent Publication No. 0253680 discloses an angle modulated signal receiving apparatus for use in a wireless receiver set. The set generates a local frequency with a crystal oscillator and mixes this local frequency with a received frequency to generate an intermediate frequency signal. A counter measures the error in the intermediate frequency signal and a control means adjusts the oscillator in response to the measured error.

German Patent No. 3626792 discloses a stabiliser that is particularly intended for a mobile radio network apparatus. The middle frequencies of the transceiver branches are self-calibrated such that the IF of the transceiver is adjusted by an AFC circuit, using several auxiliary frequencies derived from a reference oscillator as a precision frequency signal source. The adjustment and holding of the receiver IF takes place such that a signal is generated on the receiver IF by frequency synthesis from the exact reference oscillator frequency. The generated signal is stored in the receiver IF branch. An adjuster in the latter is so affected that the desired d.c. voltage mean values are adjusted at the receiver output. The adjuster control value is stored by a sample and hold circuit.

UK Patent Publication No. 2222040 discloses a communication apparatus which receives a RF Signal, that includes a frequency calibration signal, from a base station. The received RF signal is frequency down converted to derive an IF signal that is used to control the frequency of a reference oscillator. Oscillations from the oscillator are counted and an error signal is generated in accordance with the received calibration signal.

Suppose now that, in the cordless telephone set shown in Figure 2, a carrier signal Si is output from the oscillator 13 even during each reception slot R. In this state, due to the frequency of the carrier signal Si and the circuit configuration, the signal Si may leak out to the band-pass filter 27 via a signal path comprising the oscillator 13, the modulator 12, the mixer 15, the mixer 23, the band-pass filter 24 and the mixer 25, thereby causing a signal S39 which is denoted by a broken line in Figure 2. (Therefore, to avoid this problem in the telephone set mentioned above, the carrier signal Si is output only during each transmission slot T).

The signal S39 thus caused has a frequency of:

$$f39 = fi \, (1 + \alpha) - (fi - fj) \, (1 + \beta)$$

$$= fj \, (1 + \alpha)$$

where $\alpha$ is the precision of the oscillation frequency fi of the oscillator 13; $\beta$ is the precision of the oscillation frequency (fi - fj) of the oscillator 26; f39 is the frequency of the leakage signal S39 (frequency in the band-pass filter 27); and $\alpha = \beta$

Accordingly the frequency error $\Delta f$ of the leakage signal S39 is expressed as

$$\Delta f = \alpha fj$$

If fi = 450 kHz and $\alpha$ = 5 ppm for example,

$$\Delta f = 450 \times 10^{3} \times 5 \times 10^{-6}$$

$$= 2.25 \, Hz$$

The value of such error $\Delta f$ is sufficiently small that it can be ignored in comparison with the transmission-reception frequency fs.

This invention provides a time division duplex transmitter-receiver capable of dividing one channel into transmission slots and reception slots with respect to time and performing time-divided transmission and reception of data during such slots respectively, said transmitter-receiver comprising:

a transmitting circuit;
a receiving circuit;
a signal path for supplying a leakage signal from said transmitting circuit to said receiving circuit;
said transmitting circuit having means for generating a carrier signal and a modulator for modulating said carrier signal;
said receiving circuit having an oscillator for generating an oscillation signal for converting a received signal or said leakage signal into an intermediate frequency signal, and a mixer to mix said received signal with said oscillation signal;
a frequency discriminator for converting the frequency of said intermediate frequency signal obtained from said receiving circuit into a voltage; and
means operable in an automatic frequency control mode for inhibiting modulating operation of said modulator, for storing said voltage obtained from the frequency of said intermediate frequency signal obtained by conversion of said non-modulated leakage signal, and for controlling the oscillation frequency of said oscillator in dependence on said voltage.

This invention also provides a method of automatic frequency control in a time division duplex transmitter-receiver capable of dividing one channel into transmission slots and reception slots with respect to time and performing time-divided transmission and reception of data during such slots respectively, said method comprising the steps of:

generating a carrier signal with carrier signal generating means of a transmitting circuit;
modulating said carrier signal;
generating an oscillation signal in a receiving circuit having an oscillator said oscillation signal being generated for conversion of a received signal into an intermediate frequency signal;
supplying a leakage signal from said transmitting circuit to said receiving circuit via a signal path;
mixing said received signal or said leakage signal with said oscillation signal with a mixer of said receiving circuit;
converting the frequency of said intermediate frequency signal obtained from said receiving circuit into a voltage, said conversion being accomplished by a frequency discriminator;
inhibiting said modulating operation during an automatic frequency control mode;
storing said voltage obtained from the frequency of said intermediate frequency signal obtained by conversion of said non modulated leakage signal in a storage means; and
controlling the oscillation frequency of said oscillator in dependence on said voltage with controlling means.

Preferred embodiments of this invention allow an AFC function to be performed by converting the frequency of a leakage signal into a corresponding voltage and utilizing such voltage as a reference, with the frequency of oscillation being controlled in conformity with the reference voltage.

Therefore in at least a preferred embodiment of the present invention, there is provided a TDD transmitter-receiver capable of dividing one channel into transmission slots and reception slots with respect to time and performing time-divided transmission and reception of data during such slots respectively. The transmitter-receiver comprises a signal path for receiving, when connected, a signal Sr modulated by a control signal which includes a non-modulating portion, and supplying a signal from a modulator in a transmitting circuit to a receiving circuit; a frequency discriminator for converting the frequency of an intermediate frequency signal obtained from the receiving circuit into a corresponding voltage; and a memory circuit for storing the output voltage of the frequency discriminator. In this constitution, when the signal from the modulator in the transmitting circuit is supplied via the signal path to the receiving circuit, the voltage output from the frequency discriminator is stored as a reference voltage in the memory circuit; and an automatic frequency control (AFC) operation is performed by controlling both the frequency of a carrier signal supplied to the modulator in the transmitting circuit and also the frequency of a local oscillation signal supplied to the receiving circuit, in such a manner that the voltage output from the frequency discriminator during the time period of the nonmodulating portion becomes coincident with the stored reference voltage.

Again, in at least a preferred embodiment of the present invention, there is also provided a transmitter-receiver which comprises a signal path for supplying a signal S39 from a modulator in a transmitting circuit to a receiving circuit; a frequency discriminator for converting the frequency of an intermediate frequency signal obtained from the receiving circuit into a corresponding voltage; and a memory circuit for storing the output voltage of the frequency discriminator. In this constitution, when the signal from the modulator in the transmitting circuit is supplied via the signal path to the receiving circuit, the voltage output from the frequency discriminator is stored as a reference voltage in the memory circuit, and an automatic frequency control operation is performed by controlling the frequency of a carrier signal supplied to the modulator in the transmitting circuit and also the frequency of a local oscillation signal supplied to the receiving circuit, in such a manner that the voltage output from the frequency discriminator during the period of the control signal becomes coincident with the stored reference voltage.

Preferred embodiments of the invention will now be described, by way of example only, with reference to the accompanying drawings in which:

Figure 1 schematically illustrates call slots for transmission and reception;
Figure 2 is a block diagram of a previously proposed TDD transmitter-receiver;
Figure 3 is a partial block diagram of an exemplary embodiment of the present invention;
Figure 4 is a partial circuit diagram of the embodiment of the invention;
Figure 5 is a schematic diagram for explaining the operation of the embodiment;
Figures 6A, 6B and 6C are schematic diagrams for explaining a control channel; and
Figures 7A and 7B are further schematic diagrams for explaining the operation of the embodiment.

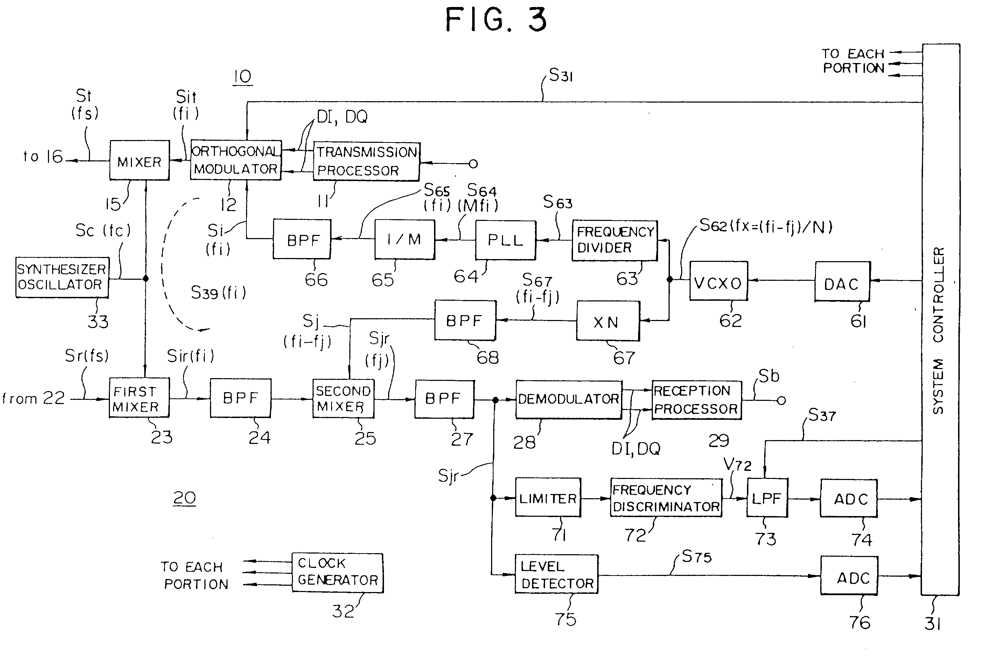

First a description will be given on the constitution and the operation of an embodiment shown in Figure 3 for transmitting an originating sound signal Sa and receiving a terminating sound signal Sb.

In Figure 3, there is provided a variable frequency oscillator VCXO 62 equipped with a quartz oscillating element to generate an oscillation signal S62 of a frequency fx = (fi - fj)/N (where N is an integer greater than 1).

The oscillation signal S62 is supplied to a frequency divider 63 to become a divided signal S63 of a predetermined frequency, which is then supplied as a reference signal to a PLL circuit (frequency multiplier) 64. The PLL circuit 64 produces an alternating signal S64 which is synchronised with the signal S63 and has a frequency Mfi (where M is an integer greater than 1 but it not equal to N). The signal S64 is supplied to a frequency divider 65 to become a divided signal S65 of a frequency fi equivalent to 1/M x the frequency of the signal S63. The signal S65 thus obtained is supplied to a band-pass filter 66 where unrequired frequency components are removed, so that an alternating signal Si of the frequency fi alone is output therefrom and is supplied as a carrier signal to a modulator 12.

In operation, power is supplied to the entire circuit continuously, with the exception that the operating voltage to the frequency divider 65 is supplied only during the transmission slot T.

Therefore, during a transmission slot T, the intermediate frequency signal (orthogonally modulated signal) Sit at the carrier frequency fi modulated by the data DI and DQ is output from the modulator 12 and is then frequency-converted to a transmission signal St at a predetermined channel frequency by mixing with the oscillation signal Sc, obtained from the oscillator 33, in the mixer 15. Thereafter the signal St thus produced is transmitted from an antenna 35.

The oscillation signal S62 from the VCXO 62 is also supplied to a multiplier 67 which multiplies the signal S62 by N to produce a signal S67 at a frequency of (fi - fj). The signal S67 is supplied to a band-pass filter 68 where unrequired frequency components are removed, so that an alternating signal Sj at the frequency (fi- fj) alone is obtained therefrom and is supplied as a second local oscillation signal to the mixer 25.

During a reception slot R, the first intermediate frequency signal Sir from the band pass filter 24 is converted to a second intermediate frequency signal Sjr at a frequency fj by mixing with the signal Sj obtained from the filter 68, and then the signal Sjr is supplied to a demodulator 28 in which the data DI and DQ are regained through demodulation.

In principle, during a reception slot R, no power is supplied to the frequency divider 65, which is thereby kept out of operation so that none of the carrier signal Si is produced during the reception slot R. This means that the leakage signal S39 in Figure 2 is not generated.

In this embodiment, an AFC function is performed as follows:

A predetermined control signal is supplied from the system controller 31 to the modulator 12 so that, when power is first applied at the start of an originating call or the like, the intermediate frequency signal (orthogonally modulated signal) Sit from the modulator 12 is initially made to be a non-modulated carrier signal.

Control data for the VCXO 62 is output from the system controller 31 and is converted into an analogue voltage by a D-A converter 61, which in turn is supplied as a control voltage to the VCXO 62.

The signal Sjr from the band-pass filter 27 is also supplied via a limiter 71 to a frequency discriminator 72, from which a DC voltage V72 at a level corresponding to the frequency of the signal Sjr is output and is supplied via a low-pass filter 73 to an A-D converter 74. The voltage V72 is converted into a digital signal and is then supplied to the system controller 31.

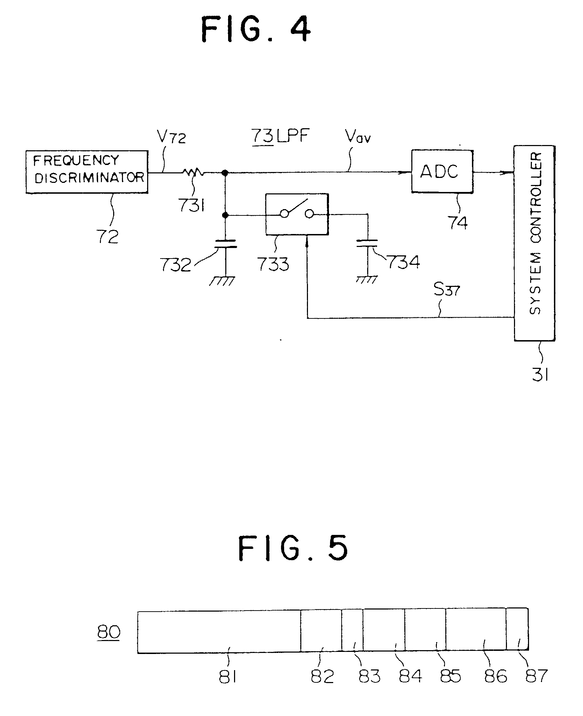

In this embodiment, the low-pass filter 73 is so formed that its time constant is variable. More specifically, as shown in Figure 4, the low-pass filter 73 comprises a resistor 731 and a capacitor 732, and a series circuit comprising a switch 733 and a capacitor 734 is connected in parallel with the capacitor 732. The capacitor 734 has a predetermined capacitance greater than that of the capacitor 732. As will be described later, the switch 733 is selectively turned on or off by the control signal S37 output from the system controller 31.

The signal Sjr from the band-pass filter 27 is also supplied to a level detector 75, which produces a signal S75 indicating the level of the intermediate frequency signal Sjr, i.e., the level of the reception signal Sr. The signal S75 is supplied via an A-D converter 76 to the system controller 31.

When the power switch is turned on, a power source (not shown) for the transmitting circuit 10 is controlled by the system controller 31 so that the frequency divider 65 is continuously powered, even during the reception slot R, so that the carrier signal Si is supplied continuously to the modulator 12. The operation of the modulator 12 is inhibited by a control signal from the system controller 31, whereby a non-modulated intermediate frequency signal (carrier signal) Sit is output continuously from the modulator 12. The receiver circuits from the mixer 23 up to the band-pass filter 27 are powered continuously, including during the transmission slot T.

Therefore, as described with regard to Figure 2, in this mode of operation the intermediate frequency signal Sit from the modulator 12 leaks out to the mixer 23 via a signal path comprising the modulator 12, the mixer 15, the mixer 23, the band-pass filter 24 and the mixer 25, so that a leakage signal S39 is sequentially converted to intermediate frequency signals Sir and Sjr by the mixers 23 and 25 respectively.

The signal Sjr from the band pass filter 27 is supplied via the limiter 71 to the frequency discriminator 72, which then produces a DC voltage V72 of a level corresponding to the frequency of the signal Sjr. The voltage V72 thus obtained is supplied to the system controller 31 by means of the low-pass filter 73 and the A-D converter 74. In this stage, the switch 733 in the low-pass filter 73 is held in its off-stage. The detection signal S75 representing the level of the received signal and output from the level detector 75 via the A-D converter 76 is checked by the system controller 31, and when the intermediate frequency signal Sjr converted from the leakage signal S39 reaches a predetermined level, the voltage V72 being supplied to the system controller 31 at that instant is stored as a reference voltage Vrf in the system controller 31.

Thus, when power is first applied, the intermediate frequency signal Sjr converted from the leakage signal S39 is stored as a reference voltage Vrf in the system controller 31. Because the carrier signal Si is formed from the frequency-divided signal S63 which in turn is derived from the oscillation signal S62 output from the VCXO 62, and the local oscillation signal Sj is formed by frequency-multiplying the signal S62, the frequency precision $\alpha$ of the signal Si and the frequency precision $\beta$ of the signal Sj are equalized to each other so that, when evaluated as a converted frequency, the error of the reference voltage Vrf stored in the system controller 31 is sufficiently small that it can be ignored in comparison with the transmission-reception frequency fs as mentioned above.

In the case of a home cordless slave telephone set or the like having no control channel through which a control signal is continuously transmitted, the switch 733 in Figure 4 is turned off in response to storage of the reference voltage Vrf, and then an originating-call request signal (connection request signal) is transmitted to the master set through a call channel. Upon reception of the originating-call request signal by the master set, an originating-call answer signal is transmitted from the master set through a call channel. Each of the originating-call request signal and the answer signal is formed as a control signal 80 which includes a non-modulating portion 81 as shown in Figure 5.

Figure 5 is a diagram schematically showing the format of the control signal 80 transferred between a master set and a slave set (cordless telephone set) when such two sets are connected to each other, i.e., when an originating call request or a terminating call request is made.

The control signal 80 has, at its start, a signal portion 81 in which the signals Sr and St are not modulated, and also has a preamble signal 82, a sync bit 83, a local identification code 84, a remote identification code 85, control bits 86 and an error detection bit 87 in that order. Therefore, when the signal Sr or St is modulated by the control signal 80, the portion of the signal Sr or St corresponding to the aforementioned signal portion 81 becomes a non-modulated carrier signal. The control bits 86 hold the information required between the master set and the slave set.

When the transmission signal Sr for the control signal 80 from the master set has been received by the cordless telephone set of Figure 3, the arrival of the transmission signal Sr is discerned by the system controller 31 on the basis of the detection signal S75 obtained from the detector 75, the and output voltage V72 of the frequency discriminator 72 during the carrier non-modulating portion 81 of the control signal 80 is input to the system controller 31.

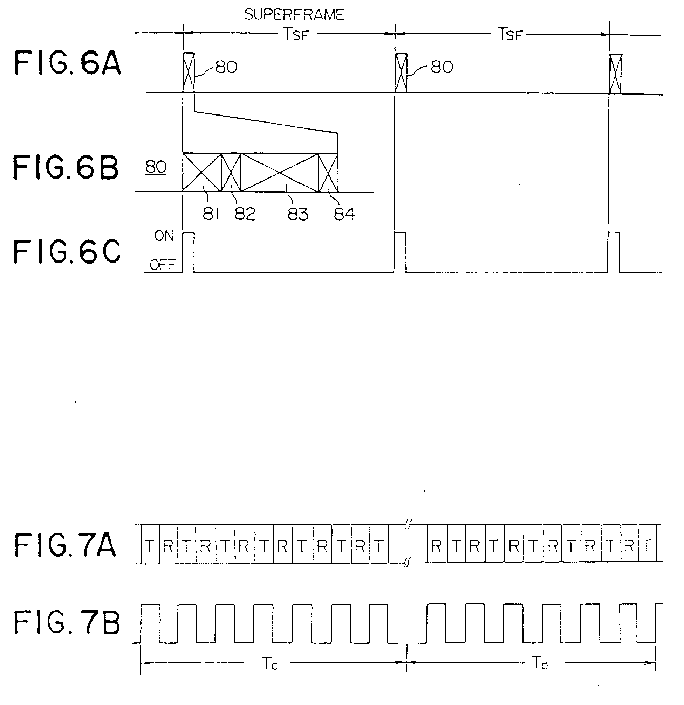

Meanwhile, in the case of a slave set (a local station) of a public cordless telephone system where a control channel for transmission of a control signal is provided in addition to an ordinary communication or call channel, an AFC action is executed upon storage of the reference voltage Vrf by using a control signal received from the base station. The base station of the public cordless telephone system transmits, through the control channel, a control signal 80 periodically at fixed intervals $T_{SF}$, termed "superframes", as shown in Figure 6A. The control signal 80 is transmitted through the channel common to the entire zone of the base station, and the interval $T_{SF}$ is the same throughout the zone. As shown in Figure 6B, the control signal 80 includes a preamble signal 81 at its start, and successively a sync signal 82, control bits 83 and an error detection bit 84 in that order. The control bits 83 hold the identification code of the base station and the information required for each cordless telephone set (slave set).

In response to the control signal 80 received per superframe $T_{SF}$, the cordless telephone set of Figure 3 selects one base station having the highest level of received signal Sr in accordance with the detection signal S75 obtained from the detector 75 and, as shown in Figure 6C, the switch 733 in Figure 4 is turned on by the control signal S37 during each of the control signals 80 (for the duration of the preamble 81), so that a voltage Vav is produced by smoothing the voltage V72 (i.e., Vav is an average of the voltage V72 obtained by frequency-discriminating the control signal 80) and is held in the capacitor 734.

In each case, if there exists any difference between the output voltage V72 or the average voltage Vav and the reference voltage Vrf stored in the system controller 31, the difference is based on the deviation of the frequency fj of the second intermediate frequency signal from the reference value (=450 kHz), and the deviation of the second intermediate frequency fj is in turn derived from the deviation of the frequency fc of the local oscillation signal Sc. Therefore, the difference voltage Vdi between the output voltage V72 or the average voltage Vav and the reference voltage Vrf signifies the deviation of the frequency fc of the local oscillation signal Sc.

The output voltage V72 or the average voltage Vav is supplied via the A-D converter 74 to the system controller 31, which then produces data to indicate the difference voltage Vdi between the output voltage V72 and the reference voltage Vrf. This data is converted into an analogue voltage by the D-A converter 61 and is then supplied as a control voltage to the VCXO 62, so that the oscillation frequency fx of the signal S62 is controlled in a direction to reduce the difference Vdi to zero, whereby the frequency fj of the second intermediate frequency signal Sjr is finally converged to the reference value. If the oscillation frequency fx of the VCXO 62 is varied to cause a change in the frequency of the second local oscillation signal Sj, the frequency of the carrier signal Si is also changed by substantially the same amount, so that the deviation of the oscillation frequency fc of the oscillator 33 is substantially cancelled by the change in the frequency of the carrier signal Si, whereby the AFC action is completed.

Subsequently the TDD process for an originating call or a terminating call is executed.

A frequency drift may occur during a call and consequently deteriorate the speech quality. Therefore the AFC action is also performed during each call. Figure 7A is a simplified diagram of the call slots shown in Figure 1. As illustrated in Figures 7A and 7B, the receiving circuit 20, particularly the line from the mixer 23 to the band-pass filter 27 therein, is placed in an operating state during each transmission slot T in a time period Tc. The switch 733 for the low-pass filter 73 is also turned on during each transmission slot T in the time period Tc by the control signal S37 obtained from the system controller 31, so that the output voltage V72 of the frequency discriminator 72 is smoothed or averaged by the capacitor 734, and then the average voltage Vav thus obtained is stored as a reference voltage Vrf in the system controller 31 as mentioned above.

The switch 733 for the low-pass filter 73 is turned on during each reception slot R in a time period Td by the control signal S37 obtained from the system controller 31, so that the output voltage V72 delivered from the frequency discriminator 72 is smoothed or averaged by the capacitor 734 to become an average voltage Vav, which is then supplied to the system controller 31 to be compared with the reference voltage Vrf stored during the time period Tc, whereby a difference voltage therebetween is obtained. The oscillation frequency of the VCXO 62 is controlled in such a manner as to reduce the difference voltage Vdi to zero.

It follows that the AFC action is performed even during a call by cyclically executing the process in the time periods Tc and Td.

In the above procedure, the master set or base station performs the same operation as that of the slave set (local station). In the case of a terminating call, the reference voltage Vrf is stored in the master set or base station in response to a ringer signal, and the mutual situation is reversed in the master set or base station and the slave set (local station). The non-modulated carrier signal Sit can be produced by supplying, instead of the aforementioned data DI and DQ, fixed-level data to the modulator 12. It is further possible to set the frequency of the second local oscillation signal Sj to (fi+fj) by determining the frequency relation to be fx=(fi+fj)/N.

In describing the above embodiment, the AFC actions for the home and public cordless telephone systems have been explained individually. However, it is rendered possible to use the terminal (slave) set and the AFC circuit for both home and public telephone systems by controlling the system controller 31 appropriately.

As described hereinabove, in at least a preferred embodiment of the invention, a TDD digital cordless telephone system operating in a submicrowave band is operable so that a leakage signal S39 output from the modulated 12 is converted into an intermediate frequency signal Sjr, and a voltage obtained by frequency-converting the signal Sjr is used as a reference voltage Vrf. The oscillation frequency fx of the VCXO 62 from which the carrier signal Si and the second local oscillation signal Sj are derived is controlled in such a manner that the voltage V72, which is obtained by frequency-discriminating the intermediate frequency signal Sjr during a carrier non-modulating signal 81 included in an originating-call request signal or during the control signal received through the control channel, becomes coincident with the reference voltage Vrf, whereby an AFC action is performed.

Furthermore, it is possible to execute the AFC action even during a call, to provide correction of the reference voltage Vrf, hence preventing deterioration of the speech quality that may otherwise be caused by any frequency drift during the call. In addition, another advantage is that a high-precision quartz oscillator where the frequency stability is less than 1 ppm is not required, thereby averting a large increase in the production cost.

## Claims

1. A time division duplex transmitter-receiver capable of dividing one channel into transmission slots (T) and reception slots (R) with respect to time and performing time-divided transmission and reception of data during such slots (T, R) respectively, said transmitter-receiver comprising:

   a transmitting circuit;
   a receiving circuit;
   a signal path (15, 33, 23) for supplying a leakage signal (S39) from said transmitting circuit (10) to said receiving circuit (20);
   said transmitting circuit (10) having means (62, 63, 64, 65, 66) for generating a carrier signal (Si) and a modulator (12) for modulating said carrier signal;
   said receiving circuit (20) having an oscillator (62, 67, 68) for generating an oscillation signal (Sj) for converting a received signal (Sir) or said leakage signal (S39) into an intermediate frequency signal (Sjr), and a mixer (25) to mix said received signal (Sir) with said oscillation signal (Sj);
   a frequency discriminator (72) for converting the frequency (fj) of said intermediate frequency signal (Sjr) obtained from said receiving circuit (20) into a voltage (V72);and

means (31, 61) operable in an automatic frequency control mode for inhibiting modulating operation of said modulator (12), for storing said voltage (V72) obtained from the frequency of said intermediate frequency signal obtained by conversion of said non-modulated leakage signal, and for controlling the oscillation frequency (fi-fj) of said oscillator (62, 67, 68) in dependence on said voltage (V72).

2. A transmitter-receiver according to claim 1, comprising means (75, 76, 31) for detecting the level of the signal (Sjr) obtained from said receiving circuit (20) and for determining whether said receiving circuit (20) has received said leakage signal (S39) from said transmitting circuit (10).

3. A transmitter-receiver according to claim 1 or claim 2, comprising means (62) for generating a common oscillation signal (S62);

means (67, 68) for deriving said oscillation signal (Sj) from said common oscillation signal (S62); and
means (63, 64, 65, 66) for deriving said carrier signal (Si) from said common oscillation signal (S62).

4. A transmitter-receiver according to any one of the preceding claims, wherein said signal path includes a mixer (15) for converting an intermediate frequency transmission signal (Sit) into a transmission signal (St) of a predetermined channel frequency (fs);

a mixer (23) for converting a received signal (Sr) of said predetermined channel frequency (fs) into a received signal (Sir) of an intermediate frequency (fi); and
a synthesizer oscillator (33) for supplying a predetermined local oscillation signal (Sc) to said mixers (15, 23).

5. A transmitter-receiver according to any one of the preceding claims, wherein said frequency discriminator (72) includes means (731, 732, 733, 734) for averaging said voltage over a predetermined time.

6. A transmitter-receiver according to claim 5, wherein said averaging means comprises a resistor (731), a first capacitor (732), and a series circuit connected in parallel with said first capacitor (732) and comprising a switch (733) and a second capacitor (734) greater in capacitance than said first capacitor.

7. A method of automatic frequency control in a time division duplex transmitter-receiver capable of dividing one channel into transmission slots (T) and reception slots (R) with respect to time and performing time-divided transmission and reception of data during such slots (T, R) respectively, said method comprising the steps of:

generating a carrier signal with carrier signal generating means (62,63,64,65,66) of a transmitting circuit (10) ;
modulating (12) said carrier signal;
generating an oscillation signal (Sj) in a receiving circuit (20) having an oscillator (63,67,68), said oscillation signal being generated for conversion of a received signal (Sir) into an intermediate frequency signal (Sjr);
supplying a leakage signal (S39) from said transmitting circuit (10) to said receiving circuit (20) via a signal path (15,33,23);
mixing said received signal (Sjr) or said leakage signal with said oscillation signal (Sj) with a mixer (25) of said receiving circuit (20);
converting the frequency (fj) of said intermediate frequency signal (Sjr) obtained from said receiving circuit (20) into a voltage (V72), said conversion being accomplished by a frequency discriminator (72);
inhibiting said modulating operation during an automatic frequency control mode;
storing said voltage (V72) obtained from the frequency of said intermediate frequency signal obtained by conversion of said non modulated leakage signal in a storage means (31) ; and
controlling the oscillation frequency (fi-fj) of said oscillator (62,67,68) in dependence on said voltage (V72) with controlling means (31,61).

8. A method according to Claim 7, wherein said leakage signal (S39) is mixed with said oscillation signal (Sj) to convert said leakage signal (S39) into an intermediate frequency signal (Sjr), the frequency of said intermediate frequency signal (Sjr) subsequently being converted into a first output voltage (Vrf), said first output voltage (Vrf) being stored in said storage means (31); said method further comprising the steps of:

receiving by said receiving circuit (20) a second non-modulated carrier signal transmitted from a remote station;
mixing said second non-modulated carrier signal with said local oscillation signal (Sj) and converting the mixed signal into a second intermediate frequency signal (Sjr);
converting the frequency (fj) of said second intermediate frequency signal (Sjr) into said voltage (V72); and
controlling the oscillation frequency (fx) of said oscillator in such a manner that said voltage (V72) becomes coincident with said first output voltage (Vfr).

9. A method according to claim 8, wherein said second non-modulated carrier signal is included in an originating-call request signal and/or an originating-call answer signal.

10. A method according to Claim 7, wherein said leakage signal (S39) is mixed with said oscillation signal (Sj) to convert said leakage signal (S39) into an intermediate frequency signal (Sjr), the frequency of said intermediate frequency signal (Sjr) subsequently being converted into a first output voltage (Vrf), said first output voltage (Vrf) being stored in said storage means (31); said method further comprising the steps of:

receiving, in said receiving circuit (20) and via a control channel, a control signal (80);
mixing said control signal (80) with said local oscillation signal (Sj) and converting the mixed signal into a second intermediate frequency signal (Sjr);
converting the frequency (fj) of said second intermediate frequency signal (Sjr) into a second output voltage (Vav); and
controlling the oscillation frequency (fx) of said oscillator in such a manner that said second output voltage (Vav) becomes coincident with said first output voltage (Vrf).

11. A method according to Claim 10, comprising the step of averaging said second output voltage (Vav).

12. A method according to Claim 7, wherein said carrier signal generated in said transmitting circuit (10) is supplied to said receiving circuit (20) for a predetermined time, said carrier signal being mixed with said oscillation signal (Sj) to convert said carrier signal into an intermediate frequency signal (Sjr), the frequency of said intermediate frequency signal (Sjr) subsequently being converted into a first output voltage (Vrf), said first output voltage (Vrf) being stored in said storage means (31); said method further comprising the steps of:

mixing a signal received by the receiving circuit (20) during reception slots (R) with said oscillation signal (Sj);
converting the mixed signal into a second intermediate frequency signal (Sjr);
converting for a predetermined time the frequency (fj) of said second intermediate frequency signal (Sj) into a second output voltage (V72); and
controlling the oscillation frequency (fx) of said oscillator in such a manner that said second output voltage (V72) becomes coincident with said first output voltage.

13. A method according to Claim 12, comprising the step of averaging said first output voltage (Vrf).

**Patentansprüche**

1. Zeitduplex-Sender-Empfänger zum Unterteilen eines Kanales in Sendeschlitze (T) und Empfangsschlitze (R) in Bezug auf die Zeit und zum Durchführen eines zeitgetrennten Sendens bzw. Empfangens von Daten während solcher Schlitze (T, R), mit:

einer Sendeschaltung,
einer Empfangschaltung,
einem Signalweg (15, 33, 23) zum Zuführen eines Lecksignales (S39) von der Sendeschaltung (10) zu der Empfangsschaltung (20),
wobei die Sendeschaltung (10) eine Einrichtung (62, 63, 64, 65, 66) zum Erzeugen eines Trägersignales (Si) und einen Modulator (12) zum Modulieren des Trägersignales aufweist,
die Empfangschaltung (20) einen Oszillator (62, 67, 68) zum Erzeugen eines Oszillationssignales (Sj) zum Umsetzen eines empfangenen Signales (Sir) oder des Lecksignales (S39) in ein Zwischenfrequenzsignal (Sjr) und einen Mischer (25) aufweist, um das empfangene Signal (Sir) mit dem Oszillationssignal (Sj) zu mischen,
einem Frequenzdiskriminator (72) zum Umsetzen der Frequenz (fj) des von der Empfangsschaltung (20) erhaltenen Zwischenfrequenzsignales (Sr) in eine Spannung (V72), und
einer Einrichtung (31, 61), die in einem automatischen Frequenzsteuermodus betrieben werden kann, zum Sperren des Modulierens des Modulators (12), zum Speichern der Spannung (V72), die aus der Frequenz (S) des durch Umsetzen des nichtmodulierten Lecksignales erhaltenen Zwischenfrequenzsignales erhalten wird, und zum Steuern der Oszillationsfrequenz (fi-fj) des Oszillators (62, 67, 68) abhängig von der Spannung (V72).

2. Sender-Empfänger gemäß Anspruch 1, mit einer Einrichtung (75, 76, 31) zum Detektieren des Pegels des von der Empfangsschaltung (20) erhaltenen Signals (Sjr) und zum Bestimmen, ob die Empfangsschaltung (20) das Lecksignal (S39) von der Sendeschaltung (10) erhalten hat.

3. Sender-Empfänger gemäß Anspruch oder Anspruch 2, mit einer Einrichtung (62) zum Erzeugen eines gemeinsamen Oszillationssignales (S62),

einer Einrichtung (67, 68) zum Ableiten des Oszillationssignales (Sj) aus dem gemeinsamen Oszillationssignal (S62), und
einer Einrichtung (63, 64, 65, 66) zum Ableiten des Trägersignales (Si) aus dem gemeinsamen Oszillationssignal (S62).

4. Sender-Empfänger gemäß einem der vorhergehenden Ansprüche, wobei der Signalweg einen Mischer (15) zum Umsetzen eines Zwischenfrequenz-Sendesignales (Sit) in ein Sendesignal (St) einer vorbestimmten Kanalfrequenz (fs), einen Mischer (23) zum Umsetzen eines empfangenen Signales (Sr) der vorbestimmten Kanalfrequenz (fs) in ein empfangenes Signal (Sir) einer Zwischenfrequenz (fi), und einen Synthesizeroszillator (33) zum Zuführen eines vorbestimmten lokalen Oszillationssignales (Sc) zu den Mischern (15, 23) aufweist.

5. Sender-Empfänger gemäß einem der vorhergehenden Ansprüche, wobei der Frequenzdiskriminator (72) eine Einrichtung (731, 732, 733, 734) zum Mitteln der Spannung über eine vorbestimmte Zeitdauer aufweist.

6. Sender-Empfänger gemäß Anspruch 5, wobei die Mittelungseinrichtung einen Widerstand (731), einen ersten Kondensator (732) und eine Reihenschaltung aufweist, die parallel mit dem ersten Kondensator (732) verbunden ist und einen Schalter (733) und einen zweiten Kondensator (734) aufweist, der eine größere Kapazität als der erste Kondensator hat.

7. Verfähren zur automatischen Frequenzsteuerung in einem Zeitduplex-Sender-Empfänger zum Unterteilen eines Kanals in Sendeschlitze (T) und Empfangsschlitze (R) in Bezug auf die Zeit und zum Durchführen eines zeitgetrennten Sendens bzw. Empfangens von Daten während derartiger Schlitze (T, R), mit den folgenden Schritten:

Erzeugen eines Trägersignales in einer Trägersignal-Erzeugungseinrichtung (62, 63, 64, 65, 66) einer Sendeschaltung (10),
Modulieren (12) des Trägersignales,
Erzeugen eines Oszillationssignales (Sj) in einer einen Oszillator (63, 67, 68) aufweisenden Empfangsschaltung (20), wobei das Oszillationssignal zum Umstezen eines empfangenen Signales (Sir) in ein Zwischenfrequenzsignal (Sjr) erzeugt wird,
Zuführen eines Lecksignales (S39) von der Sendeschaltung (10) zu der Empfangsschaltung (20) über einen Signalweg (15, 33, 23),

Mischen des empfangenen Signals (Sjr) oder des Lecksignales mit dem Oszillationssignal (Sj) in einem Mischer (25) der Empfangsschaltung (20),
Umsetzen der Frequenz (fj) des von der Empfangsschaltung (20) erhaltenen Zwischenfrequenzsignals (Sjr) in eine Spannung (V72), wobei das Umsetzen durch einen Frequenzdiskriminator (72) erfolgt,
Sperren des Modulierens während einem automatischen Frequenzsteuerungsmodus,
Speichern der Frequenz (V72), die aus der Frequenz des durch Umsetzen des nichtmodulierten Lecksignales erhaltenen Zwischenfrequenzsignales erhalten wird, in einer Speichereinrichtung (31), und
Steuern der Oszillationsfrequenz (fi-fj) des Oszillators (62, 67, 68) abhängig von der Spannung (V72) durch eine Steuereinrichtung (31, 61).

8. Verfahren gemäß Anspruch 7, wobei das Lecksignal (S39) mit dem Oszillationssignal (Sj) gemischt wird, um das Lecksignal (S39) in ein Zwischenfrequenzsignal (Sjr) umzusetzen, wobei die Frequenz des Zwischenfrequenzsignales (Sjr) danach in eine erste Ausgangsspannung (Vrf) umgesetzt wird, und die erste Ausgangsspannung (Vrf) in der Speichereinrichtung (31) gespeichert wird, mit folgenden weiteren Schritten:

Empfangen eines zweiten nichtmodulierten von einer entfernten Station übertragenen Trägersignales durch die Empfangsschaltung (20),
Mischen des zweiten nichtmodulierten Trägersignales mit dem lokalen Oszillationssignal (Sj) und Umsetzen des gemischten Signales in ein zweites Zwischenfrequenzsignal (Sjr),
Umsetzen der Frequenz (fj) des zweiten Zwischenfrequenzsignals (Sjr) in die Spannung (V72), und
Steuern der Oszillationsfrequenz (fx) des Oszillators dergestalt, daß die Spannung (V72) mit der ersten Ausgangsspannung (Vfr) zusammenfällt.

9. Verfahren gemäß Anspruch 8, wobei das zweite nichtmodulierte Trägersignal in ein Ursprungsanruf-Anforderungssignal und/oder ein Ursprungsanruf-Antwortsignal eingeschlossen wird.

10. Verfahren gemäß Anspruch 7, wobei das Lecksignal (S39) mit einem Oszillationssignal (Sj) gemischt wird, um das Lecksignal (S39) in ein Zwischenfrequenzsignal (Sjr) umzusetzen, wobei die Frequenz des Zwischenfrequenzsignales (Sjr) danach in eine erste Ausgangsspannung (Vrf) umgesetzt wird und die erste Ausgangsspannung (Vrf) in der Speichereinrichtung (31) gespeichert wird, mit folgenden weiteren Schritten:

Empfangen eines Steuersignals (80) in der Empfangsschaltung (20) und über einen Steuerkanal,

Mischen des Steuersignals (80) mit dem lokalen Oszillationssignal (Sj) und Umsetzen des gemischten Signales in ein zweites Zwischenfrequenzsignal (Sjr),

Umsetzen der Frequenz (fj) des zweiten Zwischenfrequenzsignales (Sjr) in eine zweite Ausgangsspannung (Vav), und

Steuern der Oszillationsfrequenz (fx) des Oszillators dergestalt, daß die zweite Ausgangsspannung (Vav) mit der ersten Ausgangsspannung (Vrf) zusammenfällt.

11. Verfahren gemäß Anspruch 10, mit dem Schritt des Mittelns der zweiten Ausgangsspannung (Vav).

12. Verfahren gemäß Anspruch 7, wobei das in der Sendeschaltung (10) erzeugte Trägersignal der Empfangsschaltung (20) während einer vorbestimmten Zeitdauer zugeführt wird, wobei das Trägersignal mit dem Oszillationssignal (Sj) gemischt wird, um das Trägersignal in ein Zwischenfrequenzsignal (Sjr) umzusetzen, wobei die Frequenz des Zwischenfrequenzsignales (Sjr) danach in eine erste Ausgangsspannung (Vrf) umgesetzt wird und die erste Ausgangsspannung (Vrf) in der Speichereinrichtung (31) gespeichert wird, mit folgenden weiteren Schritten:

Mischen eines durch die Empfangsschaltung (20) während Empfangsschlitzen (R) empfangenen Signales mit dem Oszillationssignal (Sj),

Umsetzen des gemischten Signales in ein zweites Zwischenfrequenzsignal (Sjr),

Umsetzen der Frequenz (fj) des zweiten Zwischenfrequenzsignales (Sj) während einer vorbestimmten Zeitdauer in eine zweite Ausgangsspannung (V72), und

Steuern der Oszillationsfrequenz (fx) des Oszillators dergestalt, daß die zweite Ausgangsspannung (V72) mit der ersten Ausgangsspannung zusammenfällt.

13. Verfahren gemäß Anspruch 12, mit dem Schritt des Mittelns der ersten Ausgangsspannung (Vrf).

**Revendications**

1. Emetteur-récepteur du type duplex à division temporelle, pouvant diviser un canal en tranches d'émission (T) et en tranches de réception (R) par rapport au temps, et effectuer une émission et une réception de données par division temporelle respectivement pendant ces tranches (T, R), ledit émetteur-récepteur comprenant :

- un circuit d'émission ;
- un circuit de réception ;
- un trajet de signal (15, 33, 23) servant à fournir audit circuit de réception (20) un signal de fuite (539) provenant dudit circuit d'émission (10) ;
- ledit circuit d'émission (10) comportant un moyen (62, 63, 64, 65, 66) servant à produire un signal de porteuse (Si) et un modulateur (12) servant à moduler ledit signal de porteuse ;
- ledit circuit de réception (20) comportant un oscillateur (62, 67, 68) servant à produire un signal d'oscillation (Sj) destiné à convertir un signal reçu (Sir) ou ledit signal de fuite (S39) en un signal de fréquence intermédiaire (Sjr), et un mélangeur (25) destiné à mélanger ledit signal reçu (Sir) avec ledit signal d'oscillation (Sj) ;
- un discriminateur de fréquence (72) servant à convertir en une tension (V72) la fréquence (fj) dudit signal de fréquence intennédiaire (Sjr) obtenu de la part dudit circuit de réception (20) ; et
- un moyen (31, 61) ayant pour fonction, dans un mode de commande automatique de fréquence, d'empêcher l'opération de modulation dudit modulateur (12), de stocker ladite tension (V72) obtenue à partir de la fréquence dudit signal de fréquence intennédiaire obtenu par conversion dudit signal de fuite non modulé, et de commander la fréquence d'oscillation (fi - fj) dudit oscillateur (62, 67, 68) en fonction de ladite tension (V72).

2. Emetteur-récepteur selon la revendication 1, comprenant un moyen (75, 76, 31) qui sert à détecter le niveau du signal (Sjr) obtenu de la part dudit circuit de réception (20) et à déterminer si ledit circuit de réception (20) a reçu ou non ledit signal de fuite (S39) de la part dudit signal d'émission (10).

3. Emetteur-récepteur selon la revendication 1 ou 2, comprenant :

- un moyen (62) servant à produire un signal d'oscillation commun (S62) ;
- un moyen (67, 68) permettant d'obtenir ledit signal d'oscillation (Sj) à partir dudit signal d'oscillation commun (S62) ; et
- un moyen (63, 64, 65, 66) permettant d'obtenir ledit signal de porteuse (Si) à partir dudit signal d'oscillation commun (S62).

4. Emetteur-récepteur selon l'une quelconque des revendications précédentes, où ledit trajet de signal comporte :

- un mélangeur (15) servant à convertir un signal d'émission de fréquence intermédiaire (Sit) en un signal d'émission (St) ayant une fréquence de canal prédéterminée (fs) ;
- un mélangeur (23) servant à convertir un signal reçu (Sr) ayant ladite fréquence de canal prédéterminée (fs) en un signal reçu (Sir) ayant une fréquence intermédiaire (fi) ; et
- un oscillateur synthétiseur (33) servant à fournir un signal d'oscillation locale prédéterminé (Sc) auxdits mélangeurs (15, 23).

5. Emetteur-récepteur selon l'une quelconque des revendications précédentes, où ledit discriminateur de fréquence (72) comporte un moyen (731, 732, 733, 734) servant à prendre la moyenne de ladite tension sur une durée prédéterminée.

6. Emetteur-récepteur selon la revendication 5, où ledit moyen de prise de moyenne comprend une résistance (731), un premier condensateur (732), et un circuit série connecté en parallèle avec ledit premier condensateur (732) et comprenant un commutateur (733) et un deuxième condensateur (734) ayant une plus grande capacité que ledit premier condensateur.

7. Procédé de commande automatique de fréquence s'appliquant dans un émetteur-récepteur du type duplex à division temporelle pouvant diviser un canal en tranches d'émission (T) et en tranches de réception (R) par rapport au temps et effectuer une émission et une réception de données en division temporelle respectivement pendant ces tranches (T, R), ledit procédé comprenant les opérations suivantes :

- produire un signal de porteuse avec un moyen de production de signal de porteuse (62, 63, 64, 65, 66) d'un circuit d'émission (10) ;
- moduler (12) ledit signal de porteuse ;
- produire un signal d'oscillation (Sj) dans un circuit de réception (20) possédant un oscillateur (63, 67, 68), ledit signal d'oscillation étant produit pour la conversion d'un signal reçu (Sir) en un signal de fréquence intennédiaire (Sjr) ;
- fournir audit circuit de réception (20), via un trajet de signal (15, 33, 23), un signal de fuite (S39) venant dudit circuit d'émission (10) ;
- mélanger ledit signal reçu (Sjr) ou ledit signal de fuite avec ledit signal d'oscillation (Sj) au moyen d'un mélangeur (25) dudit circuit de réception (20);
- convertir en une tension (V72) la fréquence (fj) dudit signal de fréquence intermédiaire (Sjr) obtenu de la part dudit circuit de réception (20), ladite conversion étant accomplie par un discriminateur de fréquence (72) ;

- invalider ladite opération de modulation lors d'un mode de commande automatique de fréquence ;
- stocker dans un moyen de stockage (31) ladite tension (V72) obtenue à partir de la fréquence dudit signal de fréquence intermédiaire résultant de la conversion dudit signal de fuite non modulé ; et
- ajuster la fréquence d'oscillation (fi - fj) dudit oscillateur (62, 67, 68) en fonction de ladite tension (V72), à l'aide d'un moyen de commande (31, 61).

8. Procédé selon la revendication 7, où on mélange ledit signal de fuite (S39) avec ledit signal d'oscillation (Sj) afin de convertir ledit signal de fuite (S39) en un signal de fréquence intermédiaire (Sjr), la fréquence dudit signal de fréquence intennédiaire (Sjr) étant ensuite convertie en une première tension de sortie (Vrf), ladite première tension de sortie (Vrf) étant stockée dans ledit moyen de stockage (31) ; ledit procédé comprenant en outre les opérations suivantes :

- recevoir, par ledit circuit de réception (20), un deuxième signal de porteuse non modulé émis depuis une station éloignée ;
- mélanger ledit deuxième signal de porteuse non modulé avec ledit signal d'oscillation locale (Sj) et convertir le signal mélangé en un deuxième signal de fréquence intermédiaire (Sjr);
- convertir la fréquence (fi) dudit deuxième signal de fréquence intennédiaire (Sjr) en ladite tension (V72) ; et
- ajuster la fréquence d'oscillation (fx) dudit oscillateur de telle manière que ladite tension (V72) vienne en coïncidence avec ladite première tension de sortie (Vfr).

9. Procédé selon la revendication 8, où ledit deuxième signal de porteuse non modulé est inclus dans un signal de demande de communication démarrant et, ou bien, un signal de réponse à une communication démarrant.

10. Procédé selon la revendication 7, où on mélange ledit signal de fuite (S39) avec ledit signal d'oscillation (Sj) afin de convertir ledit signal de fuite (S39) en un signal de fréquence intennédiaire (Sjr), la fréquence dudit signal de fréquence intennédiaire (Sjr) étant ensuite convertie en une première tension de sortie (Vrf), ladite première tension de sortie (Vrf) étant stockée dans ledit moyen de stockage (31); ledit procédé comprenant en outre les opérations suivantes :

- recevoir, dans ledit circuit de réception (20) et via un canal de commande, un signal de commande (80) ;
- mélanger ledit signal de commande (80) avec ledit signal d'oscillation locale (Sj) et convertir le signal mélangé en un deuxième signal de fréquence intermédiaire (Sjr) ;
- convertir la fréquence (fj) dudit deuxième signal de fréquence intennédiaire (Sjr) en une deuxième tension de sortie (Vav) ; et
- ajuster la fréquence d'oscillation (fx) dudit oscillateur de manière que ladite deuxième tension de sortie (Vav) vienne en coïncidence avec ladite première tension de sortie (Vrf).

11. Procédé selon la revendication 10, comprenant l'opération qui consiste à prendre la moyenne de ladite deuxième tension de sortie (Vav).

12. Procédé selon la revendication 7, où ledit signal de porteuse produit dans ledit circuit d'émission (10) est fourni audit circuit de réception (20) pendant un temps prédéterminé, ledit signal de porteuse étant mélangé avec ledit signal d'oscillation (Sj) afin de convertir ledit signal de porteuse en un signal de fréquence intermédiaire (Sjr), la fréquence dudit signal de fréquence intermédiaire (Sjr) étant ensuite convertie en une première tension de sortie (Vrf), ladite première tension de sortie (Vrf) étant stockée dans ledit moyen de stockage (31) ; ledit procédé comprenant en outre les opérations suivantes :

- mélanger un signal reçu par le circuit de réception (20) pendant des tranches de réception (R) avec ledit signal d'oscillation (Sj) ;
- convertir le signal mélangé en un deuxième signal de fréquence intermédiaire (Sjr);
- convertir, pendant un temps prédéterminé, la fréquence (fj) dudit deuxième signal de fréquence intermédiaire (Sj) en une deuxième tension de sortie (V72) ; et
- ajuster la fréquence d'oscillation (fx) dudit oscillateur de manière que ladite deuxième tension de sortie (V72) vienne en coïncidence avec ladite première tension de sortie.

13. Procédé selon la revendication 12, comprenant l'opération qui consiste à prendre la moyenne de ladite première tension de sortie (Vrf).

EP 0 500 373 B1

# FIG. 1

TRANSMISSION SLOT

RECEPTION SLOT

T

R

T

R

Tg

Tg

1ms

1ms

SEVERAL TENS OF MICROSECONDS

SEVERAL TENS OF MICROSECONDS

# FIG. 2

EP 0 500 373 B1

# FIG. 3

EP 0 500 373 B1

# FIG. 4

FREQUENCY DISCRIMINATOR

$V_{72}$

$\underline{73}$LPF

$V_{av}$

ADC

SYSTEM CONTROLLER

731

72

732

733

734

$S_{37}$

74

31

# FIG. 5

$\underline{80}$

81 82 83 84 85 86 87

FIG.6A

FIG.6B

FIG.6C

FIG.7A

FIG.7B